# EUROPEAN PATENT APPLICATION

(11) **EP 2 546 879 A2**
(43) Date of publication of application: **16.01.2013**
(21) Application number: 12175633.2
(22) Date of filing: 10.07.2012
(51) Int. Cl.: H01L 29/417, H01L 29/872

(54) **Power semiconductor device**

(30) Priority: 12.07.2011 KR 20110068935
(71) Applicant: Samsung Electronics Co., Ltd., Suwon-si, Gyeonggi-do, 443-742 (KR)
(72) Inventor: Hur, Seung Bae, 443-370 Gyeonggi-do (KR); Kim, Ki Se, 442-829 Gyeonggi-do (KR)
(74) Representative: Grünecker, Kinkeldey, Stockmair & Schwanhäusser

(57) **Abstract**

A power semiconductor device and a manufacturing method thereof are provided. The power semiconductor device includes an anode electrode (160) including an anode electrode pad (161), electrode bus lines (162a, 162b) connected to a first side (s1)and a second side (s2) on the anode electrode pad (161), the electrode bus lines (162a, 162b) each having a decreasing width in a direction away from the anode electrode pad (161), and pluralities of first anode electrode fingers (163) and second anode electrode fingers (164) connected with a third side (s3) and a fourth side (s4) on the anode electrode pad (161) and with both sides of the electrode bus line (162a, 162b), a cathode electrode (170) including a first cathode electrode pad (171) and a second cathode electrode pad (172), a plurality of cathode electrode fingers (173) connected with the first cathode electrode pad (171) , and a plurality of second cathode electrode fingers (174) connected with the second cathode electrode pad(172), and an insulation layer (180) disposed at an external portion of the anode.

## Description

### CROSS-REFERENCE TO RELATED APPLICATION

This application claims the benefit of Korean Patent Application No. 10-2011-0068935, filed on July 12, 2011, in the Korean Intellectual Property Office, the disclosure of which is incorporated herein by reference.

### BACKGROUND

### 1. Field of the Invention

The present invention relates to a power semiconductor device, and more particularly, to a power semiconductor device having an electrode array structure configured to improve uniform current spreading and a forward current.

### 2. Description of the Related Art

A Schottky diode, one of power semiconductor devices, is used in various fields including a power supply device, a vehicle, a communication device, and the like. With the increase in energy consumption, high energy efficiency besides high speed and high power is required as characteristics of the Schottky diode. To achieve the foregoing characteristics, non-uniform current spreading and decrease in a forward current need to be solved.

In a conventional Schottky diode, both an anode electrode and a cathode electrode are disposed on one surface. The anode electrode includes a single anode electrode pad disposed on one side of the one surface while the cathode electrode includes a single cathode electrode pad disposed on another side facing the anode electrode pad. In the conventional schottky diode, a current flowing area is limited and current transmission speed is low.

A current flowing from the anode electrode pad to the cathode electrode pad flows in one direction. Therefore, current crowding may be caused. Furthermore, as a plurality of electrode fingers connected to the anode electrode pad and a plurality of fingers connected to the cathode electrode pad are distanced respectively from the anode electrode pad and the cathode electrode pad, the transmitted current is weakened.

### SUMMARY

An aspect of the present invention provides a power semiconductor device capable of improving current spreading and a forward current, by disposing an anode electrode pad in a center of a nitride semiconductor layer and disposing a plurality of cathode electrode pads around the anode electrode pad, and a manufacturing method of the power semiconductor device.

Another aspect of the present invention provides a power semiconductor device capable of increasing current transmission efficiency by being provided with an electrode bus line having a decreasing width in a direction away from the anode electrode pad and a plurality of anode electrode fingers having decreasing lengths in a direction away from the anode electrode pad, and a manufacturing method of the power semiconductor device.

According to an aspect of the present invention, there is provided a power semiconductor device including an anode electrode including an anode electrode pad disposed in a center of an epi structure, electrode bus lines connected to a first side and a second side facing each other on the anode electrode pad, the electrode bus lines each having a decreasing width in a direction away from the anode electrode pad, and a plurality of first anode electrode fingers and a plurality of second anode electrode fingers connected with a third side and a fourth side facing each other on the anode electrode pad and also with both sides of the electrode bus line, a cathode electrode including a first cathode electrode pad and a second cathode electrode pad disposed to face each other with respect to the anode electrode pad, a plurality of cathode electrode fingers connected with the first cathode electrode pad and arranged alternately with the plurality of first anode electrode pads, and a plurality of second cathode electrode fingers connected with the second cathode electrode pad and arranged alternately with the plurality of second anode electrode fingers, and an insulation layer disposed at an external portion of the anode electrode to insulate the cathode electrode.

The electrode bus line may have a step structure in which width decreases stepwise in a direction away from the anode electrode pad.

The electrode bus line may have a tapered structure in which width decreases by a constant inclination angle in a direction away from the anode electrode pad.

The plurality of first anode electrode fingers and the plurality of second anode electrode fingers may have decreasing lengths in a direction away from the anode electrode pad.

The first cathode electrode pad and the second cathode electrode pad may be disposed adjacent to both side surfaces of an upper portion of the epi structure with respect to the anode electrode pad.

The first cathode electrode pad and the second cathode electrode pad may be disposed adjacent to diagonal corners of an upper portion of the epi structure with respect to the anode electrode pad.

The epi structure may include a buffer layer, an undopped nitride semiconductor layer, a nitride semiconductor layer, and a cap layer, which are sequentially formed on a substrate.

The anode electrode may be bonded to the cap layer, and the cathode electrode may be disposed on the nitride semiconductor layer exposed through the cap layer and at a predetermined interval from the anode electrode.

The nitride semiconductor layer may include a first nitride semiconductor layer disposed on the undopped nitride semiconductor layer; and a second nitride semiconductor layer disposed on the first nitride semiconductor layer.

The first nitride semiconductor layer may include aluminum nitride (AIN) and the second nitride semiconductor layer may include aluminum gallium nitride (AlGaN).

The insulation layer may be provided at external portions of the anode electrode pad, the plurality of first anode electrode fingers, and the plurality of second anode electrode fingers, which constitute the anode electrode, so as to insulate the plurality of first cathode electrode fingers and the plurality of second cathode electrode fingers constituting the cathode electrode.

The anode electrode and the cathode electrode may each include at least one metallic material selected from nickel (Ni), aluminum (Al), titanium (Ti), titanium nitride (TiN), platinum (Pt), gold (Au), ruthenium dioxide (RuO₂), vanadium (V), tungsten (W), tungsten nitride (WN), hafnium (Hf), hafnium nitride (HfN), molybdenum (Mo), nickel silicide (NiSi), cobalt silicide (CoSi₂), tungsten silicide (WSi), platinum silicide (PtSi), iridium (Ir), zirconium (Zr), tantalum (Ta), tantalum nitride (TaN), copper (Cu), ruthenium (Ru), and cobalt (Co).

### BRIEF DESCRIPTION OF THE DRAWINGS

These and/or other aspects, features, and advantages of the invention will become apparent and more readily appreciated from the following description of exemplary embodiments, taken in conjunction with the accompanying drawings of which:
FIG. 1 is a plan view illustrating a power semiconductor device according to an embodiment of the present invention;
FIG. 2 is a sectional view of the power semiconductor device of FIG. 1, cut along a line I-I';
FIG. 3 is a plan view illustrating a power semiconductor device according to another embodiment of the present invention; and
FIGS. 4 and 5 are plan views illustrating electrode bus lines according to various embodiments of the present invention.

### DETAILED DESCRIPTION

Reference will now be made in detail to exemplary embodiments of the present invention, examples of which are illustrated in the accompanying drawings, wherein like reference numerals refer to the like elements throughout. The terminology used herein is for the purpose of describing particular embodiments only and the definition may be varied according to the intention of a user, an operator, or customs. Therefore, the terms and words should be defined based on a description of this specification.

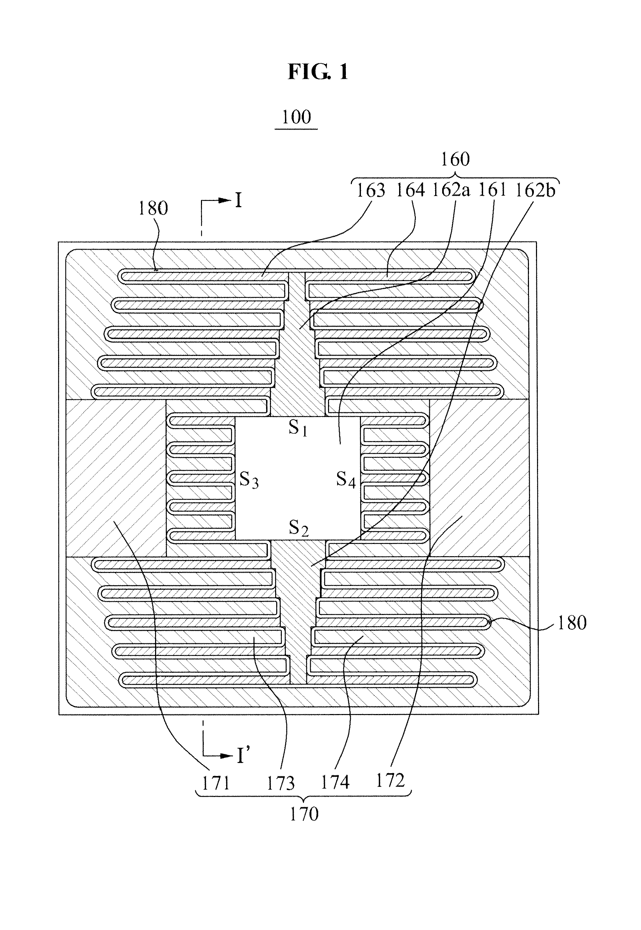

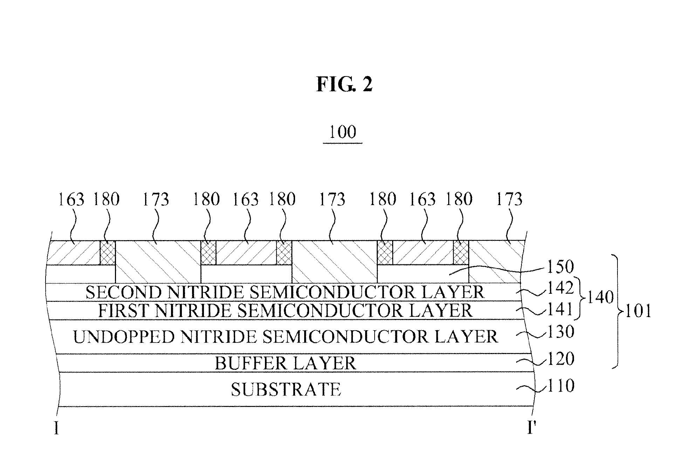

FIG. 1 is a plan view illustrating a power semiconductor device 100 according to an embodiment of the present invention. FIG. 2 is a sectional view of the power semiconductor device 100 of FIG. 1, cut along a line I-I'. Hereinafter, a structure of the power semiconductor device, particularly an electrode arrangement, will be described in detail with reference to FIGS. 1 and 2.

Referring to FIG. 2, the power semiconductor device 100, which is a heterojunction Schottky diode, may include an epi structure 101 disposed on a substrate 110, and further include an anode electrode 160, a cathode electrode 170, and an insulation layer 180 which are disposed on the epi structure 101.

The epi structure 101 may include a buffer layer 120, an undopped nitride semiconductor layer 130, a nitride semiconductor layer 140, and a cap layer 150, which are sequentially formed on a base substrate such as a silicon (Si) substrate, a silicon carbide (SiC) substrate, an aluminum nitride (AIN) substrate, a gallium nitride (GaN) substrate, or a sapphire substrate.

In the epi structure 101, the buffer layer 120 may be made of AIN and the undopped nitride semiconductor layer 130 may be made of undopped GaN.

The nitride semiconductor layer 140 may include a first nitride semiconductor layer 141 and a second nitride semiconductor layer 142. The first nitride semiconductor layer 141 may be made of AlN and disposed on the undopped nitride semiconductor layer 130. The second nitride semiconductor layer 142 may be made of aluminum gallium nitride (AlGaN) and disposed on the first nitride semiconductor layer 141.

The cap layer 150 may be disposed on the nitride semiconductor layer 140, more specifically, on the second nitride semiconductor layer 142. The cap layer 150 may be made of silicon carbide (SiC), GaN, or p-type GaN. In addition, the cap layer 150 may be disposed only on a region for forming the anode electrode 160 and the insulation layer 180. That is, the cap layer 150 is not disposed on a region for forming the second nitride semiconductor layer 142 and the cathode electrode 170. Therefore, the second nitride semiconductor layer 142 in the region for forming the cathode electrode 170 may be exposed due to the absence of the cap layer 150.

The anode electrode 160, the cathode electrode 170, and the insulation layer 180 are disposed on the epi structure 101. According to the embodiment of the present invention, the anode electrode 160 and the cathode electrode 170 are configured to improve current spreading and a forward current of the power semiconductor device 100 and to increase current transmission efficiency.

The anode electrode 160 may be disposed at an upper portion of the second nitride semiconductor layer 142 and bonded to the cap layer 150. In addition, the cathode electrode 170 may be disposed on the second nitride semiconductor layer 142 exposed through the cap layer 150, and at a predetermined interval from the anode electrode 160.

The insulation layer 180 may insulate the cathode electrode 170 disposed at an external portion of the anode electrode 160.

Referring to FIG. 1, the anode electrode 160 may include an anode electrode pad 161, electrode bus lines 162a and 162b, a plurality of first anode electrode fingers 163, and a plurality of second anode electrode fingers 164.

The anode electrode pad 161 may be disposed in a center of the second nitride semiconductor layer 142. The second nitride semiconductor layer 142 may have a rectangular upper surface. The center of the nitride semiconductor layer 142 may be determined to be an intersectional position of two diagonal lines, each of which connects diagonally facing corners of the rectangular upper surface. Since the anode electrode pad 161 is disposed in the center, a current may be uniformly spread throughout the epi structure 101.

The electrode bus lines 162a and 162b may be connected to a first side s₁ and a second side s₂, facing each other, of the anode electrode pad 161. Widths of the electrode bus lines 162a and 162b decrease in a direction away from the first side s₁ and the second side s₂ of the anode electrode pad 161, respectively.

According to an embodiment, the electrode bus lines 162a and 162b may each have a step structure in which width decreases stepwise in a direction away from first side s₁ and the second side s₂ of the anode electrode pad 161.

According to another embodiment, the electrode bus lines 162a and 162b may each have a tapered structure in which width decreases by a constant inclination angle in a direction away from the first side s₁ and the second side s₂ of the anode electrode pad 161. Thus, since the widths of the electrode bus lines 162a and 162b decrease in a direction away from the anode electrode pad 161, attenuation of the current being transmitted to a region far from the anode electrode pad 161 may be prevented.

The plurality of first anode electrode fingers 163 may be connected to a third side s₃ of the anode electrode pad 161 and to one side of each of the electrode bus lines 162a and 162b.

The plurality of second anode electrode fingers 163 are connected to a fourth side s₄ of the anode electrode pad 161, and the other side of each of the electrode bus lines 162a and 162b. The third side s₃ and the fourth side s₄ may face each other, being vertically connected with the first side s₁ and the second side s₂.

The plurality of first anode electrode fingers 163 and the plurality of second anode electrode fingers 164 may have decreasing lengths in a direction away from the anode electrode pad 161. More specifically, a nearest of the plurality of first anode electrode fingers 163 to the anode electrode pad 161 may be longest. Lengths of the plurality of first anode electrode fingers 163 may decrease in a direction away from the anode electrode pad 161. Accordingly, the plurality of first anode electrode fingers 163 may form a step structure by one end thereof. The same structure may be applied to the plurality of second anode electrode fingers 164. However, among the plurality of first anode electrode fingers 163 and the plurality of second anode electrode fingers 164, fingers in connection with the anode electrode pad 161 may have uniform lengths.

According to the aforementioned structure of the plurality of first anode electrode fingers 163 and the plurality of second anode electrode fingers 164, the current may be uniformly spread rather than concentrating around the anode electrode pad 161. In addition, since the first anode electrode fingers 163 and the second anode electrode fingers 164 have decreasing lengths in a direction away from the anode electrode pad 161 current transmission efficiency may be increased.

Referring to FIG. 1, the cathode electrode 170 may include a first cathode electrode pad 171 and a second cathode electrode pad 172, a plurality of first cathode electrode fingers 173, and a plurality of second cathode electrode fingers 174.

The first cathode electrode pad 171 and the second cathode electrode pad 172 may be disposed to face each other with respect to the anode electrode pad 161. .In particular, with respect to the anode electrode pad 161, the first cathode electrode pad 171 may be disposed at one side surface of an upper portion of the second nitride semiconductor layer 142 while the second cathode electrode pad 172 is disposed at the other side surface facing the one side surface. That is, the first cathode electrode pad 171 and the second cathode electrode pad 172 may be separately arranged at both sides with respect to the anode electrode pad 162.

The plurality of first cathode electrode fingers 173 may be alternately arranged with the plurality of first anode electrode fingers 163, being in connection with the first cathode electrode pad 171. The plurality of second cathode electrode fingers 174 may be alternately arranged with the plurality of second anode electrode fingers 164, being in connection with the second cathode electrode pad 172.

The insulation layer 180 may be disposed at external portions of the anode electrode pad 161, the plurality of first anode electrode fingers 163, and the plurality of second anode electrode fingers 164, which constitute the anode electrode 160, so as to insulate the plurality of first cathode electrode fingers 173 and the plurality of second cathode electrode fingers 174 constituting the cathode electrode 170. The insulation layer 180 may be formed of silicon dioxide (SiO₂) or silicon nitride (SiN).

The plurality of first anode electrode fingers 163 and the plurality of first cathode electrode fingers 173 may have the same width and may be at uniform intervals from one another by the insulation layer 180. Therefore, an internal pressure of the power semiconductor device 100 may be increased.

The anode electrode 160 and the cathode electrode 170 may each include at least one metallic material selected from nickel (Ni), aluminum (Al), titanium (Ti), titanium nitride (TiN), platinum (Pt), gold (Au), ruthenium dioxide (RuO₂) vanadium (V), tungsten (W), tungsten nitride (WN), hafnium (Hf), hafnium nitride (HfN), molybdenum (Mo), nickel silicide (NiSi), cobalt silicide (CoSi₂), tungsten silicide (WSi), platinum silicide (PtSi), iridium (Ir), zirconium (Zr), tantalum (Ta), tantalum nitride (TaN), copper (Cu), ruthenium (Ru), and cobalt (Co).

According to the electrode arrangement of the power semiconductor device 100 as shown in FIGS. 1 and 2, the anode electrode 160 and the cathode electrode 170 may have contacting areas with the cap layer 150 and the second nitride semiconductor layer 142 increased. As a result, a forward current may be increased during the operation of the power semiconductor device 100.

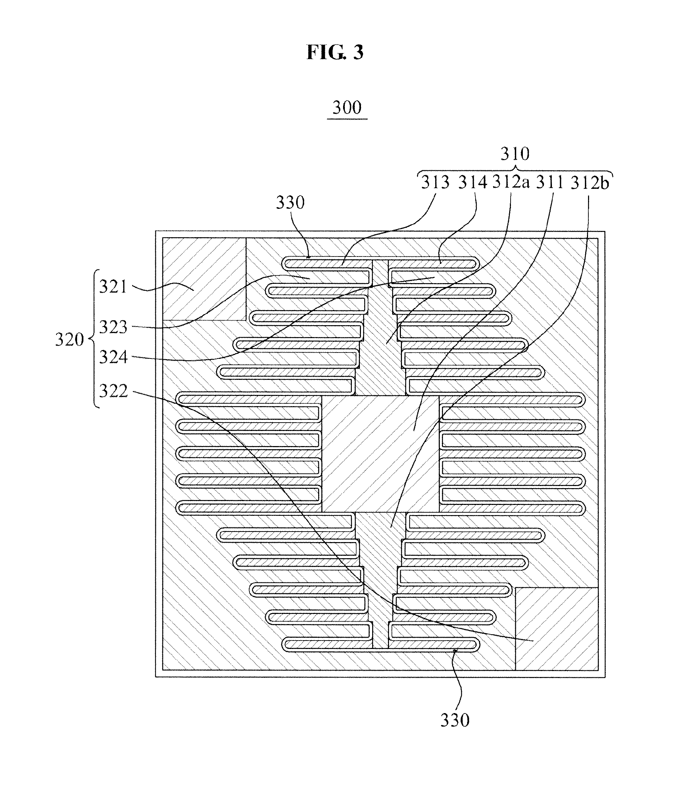

FIG. 3 is a plan view illustrating a power semiconductor device 300 according to another embodiment of the present invention. In particular, FIG. 3 illustrates an electrode arrangement of the power semiconductor device 300. The power semiconductor device 300 of FIG. 3 may have almost the same structure as the epi structure 101 of the power semiconductor device 100 shown in FIG. 2.

Referring to FIG. 3, the epi structure (not shown) may include an anode electrode 310, a cathode electrode 320, and an insulation layer 330.

The anode electrode 310 may include an anode electrode pad 311, electrode bus lines 312a and 312b, a plurality of first anode electrode fingers 313, and a plurality of second anode electrode fingers 314.

The anode electrode 310 may have a similar configuration and arrangement as the anode electrode 160 of FIG. 1. However, the arrangement of the cathode electrode 320 is altered. Therefore, among the plurality of first anode electrode fingers 313 and the plurality of second anode electrode finger 314, fingers connected to the anode electrode pad 311 may be extended up to both sides of the second nitride semiconductor layer (not shown).

The cathode electrode 320 and the anode electrode 310 are disposed at a predetermined interval. The insulation layer 330 may be disposed in the interval between the cathode electrode 320 and the anode electrode 310.

The cathode electrode 320 may include a first electrode pad 321 and a second cathode electrode pad 322, a plurality of first cathode electrode fingers 323, and a plurality of second cathode electrode fingers 324.

The first cathode electrode pad 321 and the second cathode electrode pad 322 may be disposed to face each other with respect to the anode electrode pad 311. In particular, with respect to the anode electrode pad 311, the first cathode electrode pad 321 may be disposed adjacent to one corner of an upper portion of the epi structure while the second cathode electrode pad 322 is disposed adjacent to another corner diagonally facing the one corner.

The plurality of first cathode electrode fingers 323 may be alternately arranged with the plurality of first anode electrode fingers 313, being in connection with the first cathode electrode pad 321. The plurality of second cathode electrode fingers 324 may be alternately arranged with the plurality of second anode electrode fingers 314, being in connection with the second cathode electrode pad 322.

The insulation layer 330 may be disposed at external portions of the anode electrode pad 311, the plurality of first anode electrode fingers 313, and the plurality of second anode electrode fingers 314, which constitute the anode electrode 310, so as to insulate the plurality of first cathode electrode fingers 323 and the plurality of second cathode electrode fingers 324 constituting the cathode electrode 320.

According to the electrode arrangement of the power semiconductor device as shown in FIG. 3, the anode electrode 310 and the cathode electrode 320 may have contact areas with the epi structure increased. As a result, current spreading and a forward current may be improved during the operation of the power semiconductor device 300.

Furthermore, by varying widths of the electrode bus lines 312a and 312b and lengths of the plurality of first anode electrode fingers 313 and the plurality of second anode electrode fingers 314 according to distances from the anode electrode pad 311, concentration of the current may be reduced while the current transmission efficiency is increased.

The components of the anode electrode 310, that is, the anode electrode pad 311, the electrode bus lines 312a and 312b, the plurality of first anode electrode fingers 313, and the plurality of second anode electrode fingers 314, and the components of the cathode electrode 320, that is, the first cathode electrode pad 321, the second cathode electrode pad 322, the plurality of first cathode electrode fingers 323, and the plurality of second cathode electrode fingers 324 may have sizes varied according to size of the power semiconductor device 300. That is, since a required forward current is varied according to the size to the power semiconductor device 300, the sizes of the components of the anode electrode 310 and the cathode electrode 320 may accordingly be varied.

Although not specifically shown in the drawings, the first cathode electrode 321 and the second cathode electrode pad 322 may be reduced in size while a third cathode electrode pad (not shown) and a fourth cathode electrode pad (not shown) having the same size as the first cathode electrode 321 and the second cathode electrode pad 322 are further provided. In this embodiment, the third cathode electrode pad and the fourth cathode electrode pad may be disposed adjacent to both corners diagonally facing each other with respect to the anode electrode pad 311. That is, the first cathode electrode pad 321 to the fourth cathode electrode pad may be disposed at the four corners of the epi structure, respectively.

In the case where the power semiconductor devices 100 and 300 shown in FIGS. 1 and 3 are packed into a package or mounted as a part, the anode electrode pad 311, and the first cathode electrode pad 321 and the second cathode electrode pad 322 may be connected to an external circuit pattern, such as a lead frame, using a conductive material such as a wire.

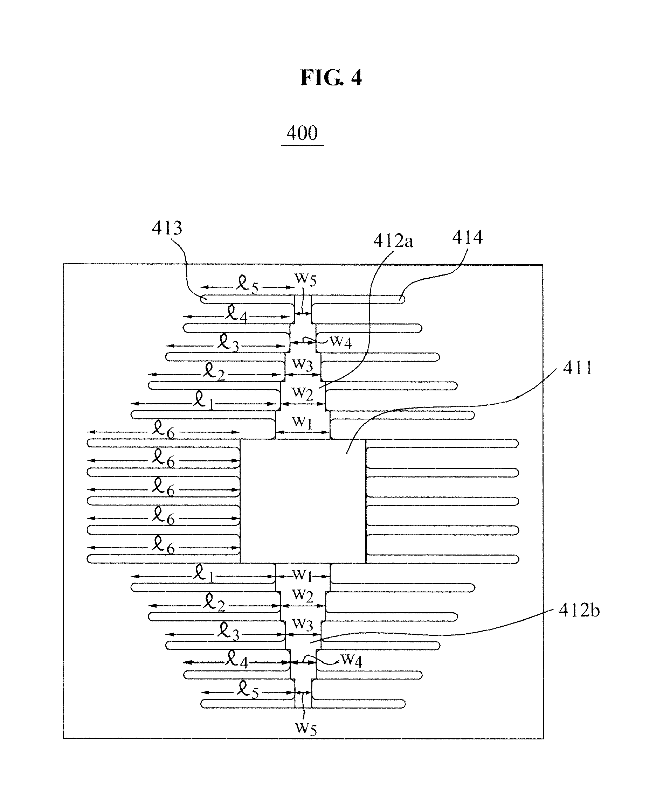

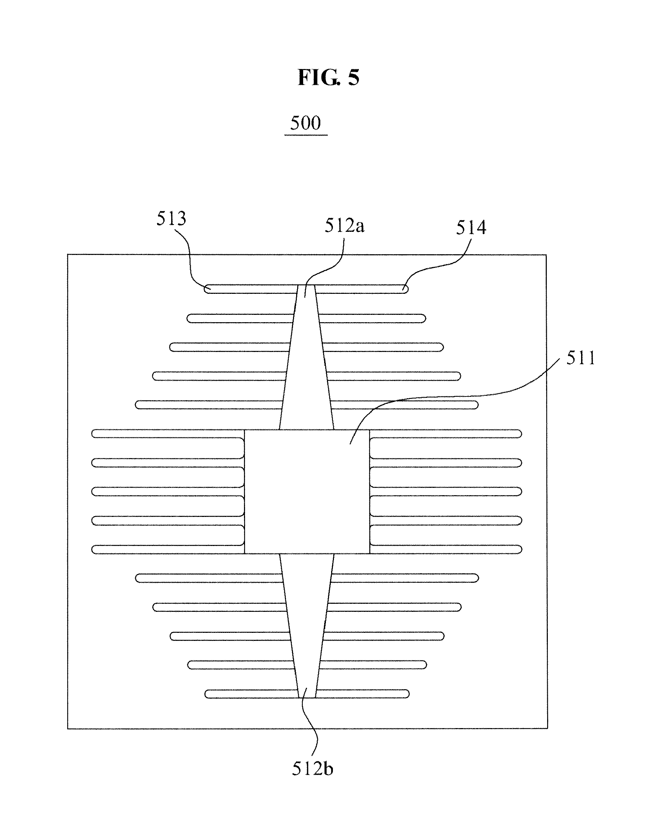

FIGS. 4 and 5 are plan views illustrating electrode bus lines according to various embodiments of the present invention. Only anode electrodes are shown in FIGS. 4 and 5 for convenience of description.

Referring to FIG. 4, the anode electrode includes an anode electrode pad 411, electrode bus lines 412a and 412b, a plurality of first anode electrode fingers 413, and a plurality of second anode electrode fingers 414. The electrode bus lines 412a and 412b may each have a step structure in which width decreases stepwise in a direction away from the anode electrode pad 411.

More specifically, each of the electrode bus lines 412a and 412b may have a greatest width, that is, a first width w₁ at a connection portion with respect to the anode electrode pad 411, and a second width w₂, a third width w₃, a fourth width w₄, and a fifth width w₅ sequentially decreasing in a direction away from the anode electrode pad 411. In addition, the electrode bus lines 412a and 412b may each form a step structure by the aforementioned widths w₁ to w₅.

The plurality of first anode electrode fingers 413 may be connected with one side of the anode electrode pad 411 and one side of each of the electrode bus lines 412a and 412b. Lengths of the plurality of first anode electrode fingers 413 are decreased in a direction away from the anode electrode pad 411.

More specifically, among the plurality of first anode electrode fingers 413 connected to the electrode bus lines 412a and 412b, a nearest finger to the anode electrode pad 411 has a first length l₁ while the other fingers have a second length l₂, a third length l₃, a fourth length l₄, and a fifth length l₅ sequentially decreasing in a direction away from the anode electrode pad 411.

However, among the plurality of first anode electrode fingers 413, fingers connected to one side of the anode electrode pad 411 may have a sixth length l₆. The sixth length l₆ may be determined according to a distance from the anode electrode pad 413 to the first cathode electrode pad (not shown) and the second cathode electrode pad (not shown), irrespective of the arrangement of the fingers.

The plurality of second anode electrode fingers 414 are connected to the other side of the anode electrode pad 411 and the other side of each of the electrode bus lines 412a and 412b. The plurality of second anode electrode fingers 414 may have the same lengths and structure, except for the connection positions, as the plurality of first anode electrode fingers 413.

Referring to FIG. 5, the anode electrode may include an anode electrode pad 511, electrode bust lines 512a and 512b, a plurality of first anode electrode fingers 513, and a plurality of second anode electrode fingers 514. The electrode bus lines 512a and 512b may have a tapered structure in which width decreases by a constant inclination angle in a direction away from the anode electrode pad 511.

In addition, as show in FIG. 5, the plurality of first anode electrode pads 513 and the plurality of second anode electrode pads 514 may have decreasing lengths in a direction away from the anode electrode pad 511.

As shown in FIGS. 4 and 5, power semiconductor devices 400 and 500 may be structured such that the anode electrode pads 411 and 511 are disposed in a center. Therefore, the current may be uniformly spread throughout the overall region. Furthermore, since the widths of the electrode bus lines 412a, 412b, 512a, and 512b and the lengths of the plurality of first anode electrode fingers 413 and 513 and the plurality of second anode electrode fingers 414 and 514 are properly varied, attenuation of the current flowing far from the anode electrode pads 411 and 511 may be prevented.

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A power semiconductor device comprising:
an anode electrode including an anode electrode pad disposed in a center of an epi structure, electrode bus lines connected to a first side and a second side facing each other on the anode electrode pad, the electrode bus lines each having a decreasing width in a direction away from the anode electrode pad, and a plurality of first anode electrode fingers and a plurality of second anode electrode fingers connected with a third side and a fourth side facing each other on the anode electrode pad and also with both sides of the electrode bus line;
a cathode electrode including a first cathode electrode pad and a second cathode electrode pad disposed to face each other with respect to the anode electrode pad, a plurality of cathode electrode fingers connected with the first cathode electrode pad and arranged alternately with the plurality of first anode electrode pads, and a plurality of second cathode electrode fingers connected with the second cathode electrode pad and arranged alternately with the plurality of second anode electrode fingers; and
an insulation layer disposed at an external portion of the anode electrode to insulate the cathode electrode.

2. The power semiconductor device of claim 1, wherein the electrode bus line has a step structure in which width decreases stepwise in a direction away from the anode electrode pad.

3. The power semiconductor device of claim 1, wherein the electrode bus line has a tapered structure in which width decreases by a constant inclination angle in a direction away from the anode electrode pad.

4. The power semiconductor device of claim 1, wherein the plurality of first anode electrode fingers and the plurality of second anode electrode fingers have decreasing lengths in a direction away from the anode electrode pad.

5. The power semiconductor device of claim 1, wherein the first cathode electrode pad and the second cathode electrode pad are disposed adjacent to both side surfaces of an upper portion of the epi structure with respect to the anode electrode pad.

6. The power semiconductor device of claim 1, wherein the first cathode electrode pad and the second cathode electrode pad are disposed adjacent to diagonal comers of an upper portion of the epi structure with respect to the anode electrode pad.

7. The power semiconductor device of claim 1, wherein the epi structure comprises a buffer layer, an undopped nitride semiconductor layer, a nitride semiconductor layer, and a cap layer, which are sequentially formed on a substrate.

8. The power semiconductor device of claim 7, wherein
the anode electrode is bonded to the cap layer, and
the cathode electrode is disposed on the nitride semiconductor layer exposed through the cap layer and at a predetermined interval from the anode electrode.

9. The power semiconductor device of claim 7, wherein the nitride semiconductor layer comprises:
a first nitride semiconductor layer disposed on the undopped nitride semiconductor layer; and
a second nitride semiconductor layer disposed on the first nitride semiconductor layer.

10. The power semiconductor device of claim 9, wherein the first nitride semiconductor layer comprises aluminum nitride (AIN) and the second nitride semiconductor layer comprises aluminum gallium nitride (AlGaN).

11. The power semiconductor device of claim 1, wherein the insulation layer is provided at external portions of the anode electrode pad, the plurality of first anode electrode fingers, and the plurality of second anode electrode fingers, which constitute the anode electrode, so as to insulate the plurality of first cathode electrode fingers and the plurality of second cathode electrode fingers constituting the cathode electrode.

12. The power semiconductor device of claim 1, wherein the anode electrode and the cathode electrode each comprise at least one metallic material selected from nickel (Ni), aluminum (Al), titanium (Ti), titanium nitride (TiN), platinum (Pt), gold (Au), ruthenium dioxide (RuO₂), vanadium (V), tungsten (W), tungsten nitride (WN), hafnium (Hf), hafnium nitride (HfN), molybdenum (Mo), nickel silicide (NiSi), cobalt silicide (CoSi₂), tungsten silicide (WSi), platinum silicide (PtSi), iridium (Ir), zirconium (Zr), tantalum (Ta), tantalum nitride (TaN), copper (Cu), ruthenium (Ru), and cobalt (Co).
